# EUROPEAN PATENT SPECIFICATION

(11) **EP 3 090 270 B1**
(45) Date of publication and mention of the grant of the patent: **02.02.2022**
(21) Application number: 14833258.8
(22) Date of filing: 19.12.2014
(51) Int. Cl.: G01R 31/34

(54) **DEVICE AND METHOD FOR INSPECTING AN ALTERNATOR**
VORRICHTUNG UND VERFAHREN ZUR INSPEKTION EINES WECHSELSTROMGENERATORS
DISPOSITIF ET PROCÉDÉ D'INSPECTION D'ALTERNATEUR

(30) Priority: 31.12.2013 IT MI20132223
(43) Date of publication of application: 09.11.2016
(73) Proprietor: Ansaldo Energia S.p.A., 16152 Genova (IT)
(72) Inventor: D'AGOSTINO, Fabrizio, I-16143 Genova (IT); MACELLONI, Paolo, I-16152 Genova (IT); DI LIDDO, Sergio, I-16142 Genova (IT); CARASSALE, Riccardo, I-16152 Genova (IT); MARTORANA, Gianfranco, I-16152 Genova (IT)
(74) Representative: Andreotti, Erika
(86) International application number: PCT/IB2014/067146
(87) International publication number: WO 2015/101894

(56) References cited:
- EP-A1- 2 071 343
- EP-A2- 0 684 483
- US-A- 5 105 658
- US-A1- 2002 135 383
- US-A1- 2005 093 536

## Description

### TECHNICAL FIELD

The present invention relates to a device and to a method for inspecting an alternator.

In particular, the present invention relates to a device and to a method for inspecting parts of a stator of an alternator of a plant for electric energy production with rotor inserted.

### BACKGROUND ART

Alternators for generating electric energy often contemplate activities involving the inspection of parts of the stator, with the aim of preventing the occurrence of failures. Sometimes, such inspections are carried out following the detection of anomalies or malfunctions of the alternator.

In any case, during the inspection steps the need to monitor the condition of the stator windings inside the slots is felt in order to check the condition of the electric insulation by detecting visible faults or the occurrence of partial discharges.

Failure to detect such faults could lead to irreversible damage of the winding, sooner or later.

Such a monitoring activity is usually carried out by means of inspection probes of known type. Examples of inspection probes are disclosed in documents US5105658, EP0684483, US2002/135383, US2005/093536, EP2071343.

However, such probes have a very limited possibility of inspection. They are indeed introduced through the ventilation channels usually used to circulate the coolant, thus allowing an inspection that is limited only to stator slots provided with ventilation channels and only related to the lower part of the stator pack.

Other inspection devices which do not take advantage of the ventilation channels are also known. However, these devices are limited to the visual inspection alone of the superficial portion of the stator overlooking the air gap, thus making a thorough and reliable analysis of the insulation conditions of the stator bars impossible.

Further, more advanced inspection devices instead require disassembling the rotor, with apparent disadvantages in terms of costs and intervention times.

### DISCLOSURE OF INVENTION

It is thus one object of the present invention to make a device for inspecting an alternator which allows to overcome the limitations of the known art.

In particular, it is one object of the present invention to make a device for inspecting an alternator which does not require the disassembly of the rotor and at the same time, performs a detailed and reliable inspection of the alternator, with particular attention on the insulation system of the electrical windings.

In accordance with such objects, the present invention relates to a device for inspecting an alternator according to claim 1.

It is a further object of the invention to provide a method for inspecting an alternator which allows to overcome the drawbacks highlighted by the known methods in a simple and affordable manner, and which at the same time allows to ensure a reliable and punctual inspection of the alternator, and in particular of the insulation system of the stator bars of the alternator.

In accordance with such objects, the present invention relates to a method for inspecting an alternator according to claim 11.

### BRIEF DESCRIPTION OF THE DRAWINGS

Further features and advantages of the present invention will become more apparent from the following description of a non-limiting embodiment thereof, with reference to the figures of the accompanying drawings, in which:
- figure 1 is a diagrammatic side view, with sectional parts and parts removed for clarity, of an alternator and of a device for inspecting the alternator in a first operating position;
- figure 2 is a front diagrammatic view, with sectional parts and parts removed for clarity, of the device for inspecting the alternator in figure 1;
- figure 3 is a perspective top view, with sectional parts and parts removed for clarity, of the inspection device shown in figure 1;
- figure 4 is a diagrammatic side view, with sectional parts and parts removed for clarity, of a detail of figure 1;
- figure 5 is a perspective bottom view, with sectional parts and parts removed for clarity, of the inspection device shown in figure 1.

### BEST MODE FOR CARRYING OUT THE INVENTION

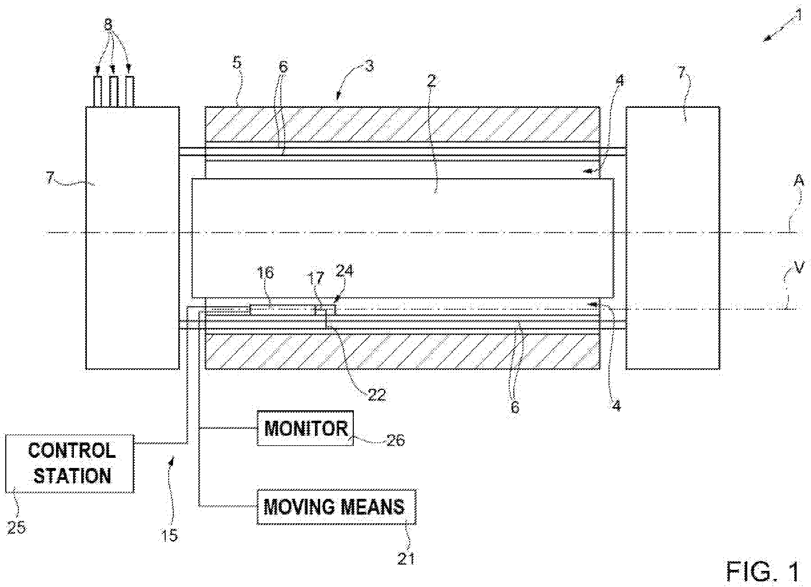

With reference to figure 1, numeral 1 indicates an alternator, as a whole, which extends along a longitudinal axis A and comprises a rotor 2, which is the inductor and is the movable part of turboalternator 1, and a stator 3, which is the armature and is the fixed part of the turboalternator.

Rotor 2 is substantially cylindrical shaped and rotates - moved by a turbine (not illustrated) - about its own axis, which coincides with the longitudinal axis A of alternator 1.

Stator 3 is a hollow cylinder which is coaxial with rotor 2, which extends outside rotor 2. The space comprised between rotor 2 and stator 3 is called air gap 4.

Stator 3 comprises a cylindrical core 5, which extends along the longitudinal axis A, a plurality of electrical windings 6 (only some of which are shown diagrammatically in figure 1), two heads 7 arranged at the ends of stator 3 and of terminals 8 for drawing the current. The windings 6 are crossed by a current induced by the rotation of rotor 2.

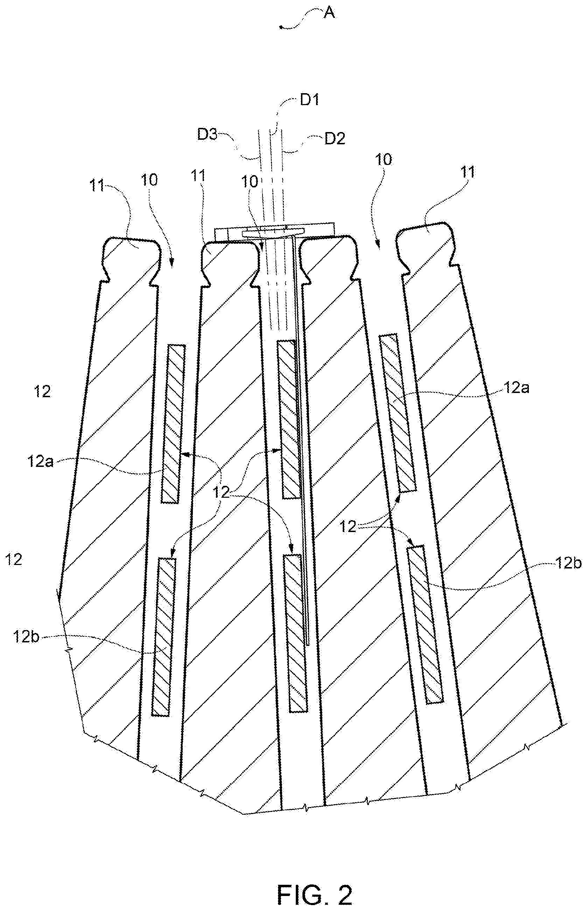

With reference to figure 2, the cylindrical core 5 has a plurality of axial grooves, called slots 10, which extend for the entire length of the cylindrical core 5. The slots 10 are separated and delimited by longitudinal projections 11, which are parallel to axis A.

Each winding 6 comprises a plurality of conductor bars 12, each of which is arranged in part along a defined path inside the slots 10, and in part at the heads 7 (figure 1). Each electrical winding 6 is therefore arranged in several slots 10. In particular, each winding 6 passes through a first slot 10, comes out of the first slot 10 at a head 7 (figure 1) to then enter a second slot 10 and comes out at the opposite head 7 (figure 1), enters a third slot 10 and so on, for a number of times defined in the project.

In particular, each slot 10 accommodates two bars 12: a hollow external bar 12a and a hollow internal bar 12b.

Figures 1 and 2 show a device 15 for inspecting alternator 1 according to the present invention.

With particular reference to figure 1, device 15 is arranged in the air gap 4 and is configured for inspecting stator 3 of alternator 1 with rotor 2 assembled.

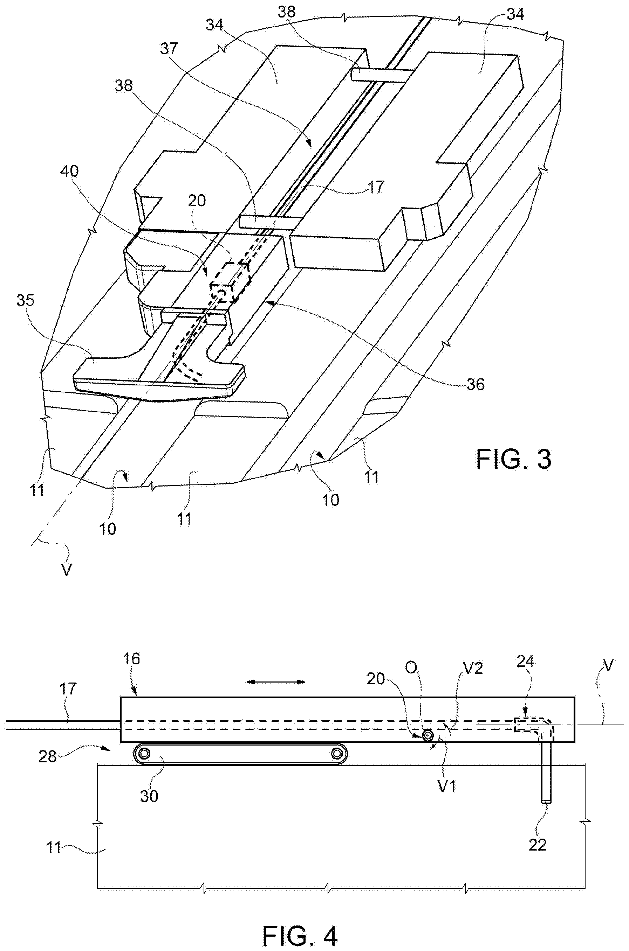

Device 15 comprises a carriage 16, a probe 17, first moving means 20 configured for moving probe 17 along a moving axis V belonging to a moving plane (shown in figures 3 and 4), second moving means 21 (diagrammatically shown in figure 1) connected to probe 17 and configured for moving a free end 22 of probe 17, at least a first driving element 24 (best shown in figures 3 and 4) shaped for deflecting probe 17 along a first direction D1 transversal to the moving axis V on a first side of the moving plane, a control station 25 and a monitor 26 connected to probe 17.

With reference to figures 3 and 4, carriage 16 is arranged preferably resting on core 5 and is movable along a direction parallel to axis A. In the non-limiting embodiment herein described and illustrated, carriage 16 moves substantially along the moving axis V.

In detail, carriage 16 is provided with a moving system 28 (partly shown in figure 4) which is controlled remotely by means of the control station 25.

In the non-limiting embodiment herein described and illustrated, the moving system 28 comprises an electric motor (not illustrated in the accompanying figures for simplicity), two tracks 30 (one of which is diagrammatically illustrated in figure 4) and drive means (not illustrated in the accompanying figures for simplicity) configured to transmit the motion of the electric motor to the tracks 30.

In use, each track 30 is arranged resting on a respective projection 11 of core 5 of stator 3.

In the non-limiting embodiment herein described and illustrated, the tracks 30 and/or the drive means are coupled to elements made of magnetic material so as to ensure a secure and reliable adhesion of the tracks 30 to the respective projections 11 of the entire core 5, including the upper portion of core 5.

Variants (not illustrated) provide for other elements of carriage 16 to be made of magnetic material to ensure the adhesion between carriage 16 and the projections 11 to which carriage 16 is to be coupled.

With reference to figure 3, carriage 16 comprises two main bodies 34, each of which is coupled to a respective track 30, a head 35 and a middle portion 36 arranged between the head and the two main bodies 34.

The two main bodies 34 are arranged side by side, extend parallel to one another and are coupled to each other by means of a connection system 37.

In the non-limiting embodiment herein described and illustrated, the connection system 37 is configured so that the distance between the main bodies 34 is adjustable. For example, the connection system 37 comprises two tubular elements 38, telescopic tubular elements.

Due to the possibility of adjusting the distance between the main bodies 34, the distance between the centers of the tracks 30 may be adjusted so that each track 30 is coupled to the respective projection 11 of the cylindrical core 5 of stator 3. Thereby, device 15 according to the present invention may be engaged on alternators of different sizes in which the distance is variable between the projections 11 of core 5.

It is understood that carriage 16 may comprise a single main body coupled to the tracks 30 and that the distance between the centers of the tracks 30 is in any case adjustable.

The middle portion 36 is preferably coupled to one of the two main bodies 34 and supports probe 15 along the moving axis V.

Preferably, the middle portion 36 comprises an accommodating seat 40 configured for accommodating the first moving means 20 of probe 17.

With reference to figure 4, the first moving means 20 of probe 17 comprise an electric motor (not illustrated for simplicity), at least one roller 41 arranged against probe 17, and drive means for transmitting the motion of the motor to roller 41.

Roller 41 rotates with respect to an axis O which is orthogonal to the moving axis V of probe 17.

Roller 41 may rotate in a first direction V1 to obtain a forward movement of probe 17 along the moving axis V, and in a second direction V2 to obtain a reverse movement of probe 17 along the moving axis V.

The operation of the electric motor of the moving means 20 and the setting of the direction of rotation of roller 41 is automatically regulated by the control station 25 or following a manual adjustment.

In use, the operation of the electric motor determines the advancing of carriage 16 along the moving axis V.

The second moving means 21 are configured to move the free end 22 of probe 17.

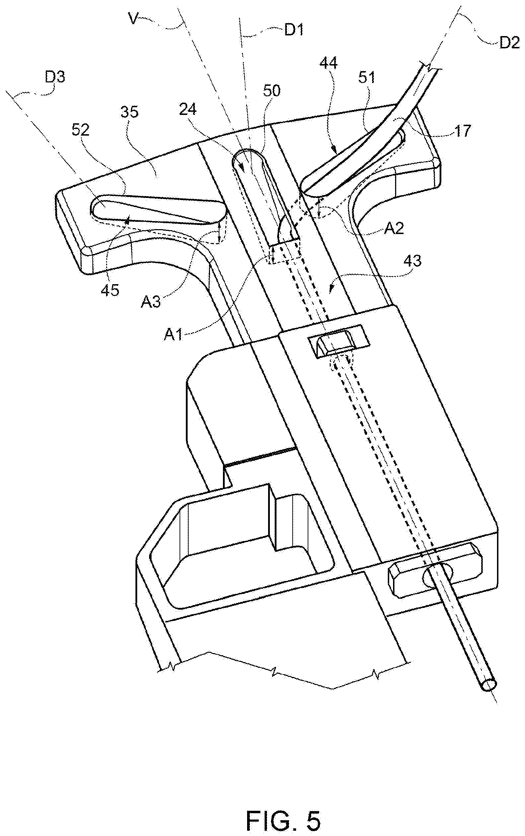

With reference to figure 5, head 35 comprises a main conduit 43, the first driving element 24, which extends substantially along the moving axis V, a second driving element 44 and a third driving element 45. The second driving element 44 and the third driving element 45 are arranged preferably symmetrical with respect to the moving axis V and extend along respective directions.

Similarly to the first driving element 24, the second driving element 44 and the third driving element 45 are shaped so as to deflect probe 17 in a respective second direction D2 and in a respective third direction D3 on the first side of the moving plane.

The second direction D2 and the third direction D3 are both transversal to the moving axis V of probe 17.

The main conduit 43 drives probe 17 along the moving axis V and is in communication with the first driving element 24, the second driving element 44 and the third driving element 45 by means of respective inlet mouths.

In the non-limiting embodiment herein described and illustrated, the first driving element 24, the second driving element 44 and the third driving element 45 are defined by respective grooves 50, 51, 52 obtained on head 35. Each groove 50, 51, 52 has a progressively decreasing depth A1, A2, A3 so as to deflect the probe in the respective direction D1, D2, D3.

Specifically, depth A1, A2, A3 of each groove 50, 51, 52 decreases in the advancing direction of probe 17, which is determined by the rotation of roller 41 in direction V₁.

In use, the free end 22 of probe 17 is moved by the moving means 21 under the control of the control station 25 so as to engage, according to the needs, one from the first driving element 24, the second driving element 44 and the third driving element 45.

Preferably, the control station 25 is provided with a manual control (not illustrated) (joystick) capable of controlling the movement of end 22 of probe 17.

The movement of probe 17 set by the rotation of roller 41 in direction V₁ determines a forward movement of probe 17 inside the respective driving element 24, 44 and 45 and a deflection of probe 17 in the respective direction D1, D2 and D3.

The driving elements 24, 44 and 45 are arranged so that, in use, once deflected probe 17 penetrates inside a slot 10 in different directions to completely inspect slot 10 and the bars 12 contained therein.

With reference to figure 2, the first driving element 24 determines a deflection of probe 17 in direction D1 in a first portion inside a slot 10, the second driving element 44 determines a deflection of probe 17 in direction D2 of a second portion inside slot 10, and the third driving element 45 determines a deflection of probe 17 in direction D3 inside slot 10. Thereby, device 15 according to the present invention is capable of thoroughly inspecting each slot 10.

Furthermore, with the same device 15 it is possible to thoroughly inspect the surface of the bars positioned inside the slots adjacent to the slot being inspected, which is visible through the ventilation channels.

It is understood that the number of driving elements herein described and illustrated is purely indicative. A variant (not illustrated) provides for the driving elements to be greater than three so as to direct the probe, for example, onto further slots of core 5 of stator 3.

A variant (not illustrated) contemplates for each driving element 24, 44 and 45 to be provided with means configured to selectively occlude the respective inlet mouths. Such means are controllable from the control station 25. Thereby, the selective occlusion of two inlet mouths drives probe 17 toward the driving element with the inlet mouth not occluded. Such a variant allows the elimination of the second moving means 21 for moving the free end 22.

Advantageously, device 15 according to the present invention allows the complete inspection of the bars 12 that define the windings 6 in alternators 1 with rotor 2 assembled. Not only is it possible due to this aspect to inspect the bars 12 during scheduled maintenance operations, but also during extraordinary maintenance operations without requiring the disassembly of machine components which would excessively slow down the operability of the plant on which alternator 1 is assembled.

Furthermore, device 15 according to the present invention does not engage the ventilation channels of the stator and therefore does not require such channels to be emptied of the coolant contained therein, with apparent advantages in terms of intervention times and costs.

Finally, device 15 according to the present invention is easy and affordable to make and allows ordinary inspection costs to be significantly reduced by avoiding the disassembly of the rotor.

Finally, it is apparent that modifications and variants may be made to the device and the method herein described without departing from the scope of the accompanying claims.

## Claims

1. Device (15) for inspecting an alternator of a plant for electric energy production comprising:
- a probe (17);
- first moving means (20) configured for moving the probe (17) along a moving axis (V) lying on a moving plane;
- at least a first driving element (24, 44, 45) shaped for deflecting the probe (17) in a first direction (D1, D2, D3) transversal to the moving axis (V) on a first side of the plane;
the device being **characterized in that**, in use, the driving element (24, 44, 45) is arranged so that, once deflected, the probe (17) penetrates inside one slot (10) of the alternator.

2. Device according to claim 1, comprising at least a second driving element (44, 45, 24) shaped for deflecting the probe (17) in a second direction (D2, D3, D1) transversal to the moving axis (V) on a first side of the plane.

3. Device according to claim 2, comprising at least a third driving element (45, 24, 44) shaped for deflecting the probe (17) in a third direction (D3, D1, D2) transversal to the moving axis (V) on a first side of the plane.

4. Device according to anyone of the foregoing claims, comprising a control station (25) configured to control the first moving means (20).

5. Device according to claim 4, comprising second moving means (21) configured to move an end (22) of the probe (17) .

6. Device according to claim 5, wherein the control station (25) is configured to control the second moving means (21) .

7. Device according to any one of claims from 4 to 6, wherein the control station (25) comprises at least a first manual control configured to control the first moving means (20) .

8. Device according to anyone of the foregoing claims, comprising at least an image detector and at least a monitor (26), coupled to the probe (17).

9. Device according to anyone of the foregoing claims comprising a carriage (16) provided with a moving system (28); the carriage (16) being configured for supporting, at least in part, the probe (17) and the first driving element (24, 44, 45).

10. Device according to claim 9, wherein the carriage (16) comprises at least an element made of magnetic material.

11. Method for inspecting an alternator (1) of a plant for electric energy production comprising the steps of:
arranging a probe (17) in an air gap (4) of the alternator (1);
moving the probe (17) along a moving axis (V) lying on a moving plane;
deflecting the probe (17) along a first direction (D1, D2, D3) transversal to the moving axis (V) on a first side of the plane;
detecting images by means of the probe (17);
the method being **characterized in that** the step of deflecting the probe (17) comprises deflecting the probe (17) so that, once deflected, the probe (17) penetrates inside one slot (10) of the alternator.

12. Method according to claim 11, comprising the step of deflecting the probe (17) along a second direction (D2, D3, D1) transversal to the moving axis (V) on a first side of the plane.

13. Method according to claim 12, comprising the step of deflecting the probe along a third direction (D3, D2, D1) transversal to the moving axis (V) on a first side of the plane.

14. Method according to any one of claims from 11 to 13, comprising the step of moving an end (22) of the probe (17) .

15. Method according to any one of claims from 11 to 14, wherein the step of arranging a probe (17) in an air gap (4) of the alternator (1) is performed without disassembling a rotor (2) of the alternator (1).

16. Method according to any one of claims from 11 to 15, wherein the step of arranging a probe (17) in an air gap (4) of the alternator (1) is performed without disassembling heads (7) of the alternator (1).

## Patentansprüche

1. Vorrichtung (15) zur Inspektion eines Wechselstromgenerators einer Anlage zur Erzeugung von elektrischer Energie, umfassend:
- eine Sonde (17);
- eine erste Bewegungseinrichtung (20), die dafür konfiguriert ist, die Sonde (17) entlang einer auf einer Bewegungsebene liegenden Bewegungsachse (V) zu bewegen;
- mindestens ein erstes Antriebselement (24, 44, 45), das dafür geformt ist, die Sonde (17) in eine erste Richtung (D1, D2, D3) quer zu der Bewegungsachse (V) auf einer ersten Seite der Ebene auszulenken;
wobei die Vorrichtung **dadurch gekennzeichnet ist, dass** bei der Verwendung das Antriebselement (24, 44, 45) so angeordnet ist, dass, sobald sie ausgelenkt ist, die Sonde (17) in einen Schlitz (10) des Wechselstromgenerators eindringt.

2. Vorrichtung nach Anspruch 1, umfassend mindestens ein zweites Antriebselement (44, 45, 24), das dafür geformt ist, die Sonde (17) in eine zweite Richtung (D2, D3, D1) quer zu der Bewegungsachse (V) auf einer ersten Seite der Ebene auszulenken.

3. Vorrichtung nach Anspruch 2, umfassend mindestens ein drittes Antriebselement (45, 24, 44), das dafür geformt ist, die Sonde (17) in einer dritten Richtung (D3, D1, D2) quer zu der Bewegungsachse (V) auf einer ersten Seite der Ebene auszulenken.

4. Vorrichtung nach einem der vorhergehenden Ansprüche, umfassend eine Steuerstation (25), die dafür konfiguriert ist, die erste Bewegungseinrichtung (20) zu steuern.

5. Vorrichtung nach Anspruch 4, umfassend eine zweite Bewegungseinrichtung (21), die dafür konfiguriert ist, ein Ende (22) der Sonde (17) zu bewegen.

6. Vorrichtung nach Anspruch 5, wobei die Steuerstation (25) dafür konfiguriert ist, die zweite Bewegungseinrichtung (21) zu steuern.

7. Vorrichtung nach einem der Ansprüche von 4 bis 6, wobei die Steuerstation (25) mindestens eine erste manuelle Steuerung umfasst, die dafür konfiguriert ist, die erste Bewegungseinrichtung (20) zu steuern.

8. Vorrichtung nach einem der vorhergehenden Ansprüche, umfassend mindestens eine Bilderfassungseinrichtung und mindestens einen Monitor (26), die mit der Sonde (17) gekoppelt sind.

9. Vorrichtung nach einem der vorhergehenden Ansprüche, umfassend einen Wagen (16), der mit einem Bewegungssystem (28) versehen ist, wobei der Wagen (16) dafür konfiguriert ist, zumindest teilweise die Sonde (17) und das erste Antriebselement (24, 44, 45) zu tragen.

10. Vorrichtung nach Anspruch 9, wobei der Wagen (16) mindestens ein aus einem magnetischen Material hergestelltes Element umfasst.

11. Verfahren zur Inspektion eines Wechselstromgenerators (1) einer Anlage zur Erzeugung von elektrischer Energie, umfassend die Schritte:
Anordnen einer Sonde (17) in einem Luftspalt (4) des Wechselstromgenerators (1);
Bewegen der Sonde (17) entlang einer auf einer Bewegungsebene liegenden Bewegungsachse (V);
Auslenken der Sonde (17) entlang einer ersten Richtung (D1, D2, D3) quer zu der Bewegungsachse (V) auf einer ersten Seite der Ebene;
Erfassen von Bildern mittels der Sonde (17);
wobei das Verfahren **dadurch gekennzeichnet ist, dass** der Schritt des Auslenkens der Sonde (17) das Auslenken der Sonde (17) in der Weise umfasst, dass, sobald sie ausgelenkt ist, die Sonde (17) in einen Schlitz (10) des Wechselstromgenerators eindringt.

12. Verfahren nach Anspruch 11, umfassend den Schritt des Auslenkens der Sonde (17) entlang einer zweiten Richtung (D2, D3, D1) quer zu der Bewegungsachse (V) auf einer ersten Seite der Ebene.

13. Verfahren nach Anspruch 12, umfassend den Schritt des Auslenkens der Sonde (17) entlang einer dritten Richtung (D3, D2, D1) quer zu der Bewegungsachse (V) auf einer ersten Seite der Ebene.

14. Verfahren nach einem der Ansprüche von 11 bis 13, umfassend den Schritt des Bewegens eines Endes (22) der Sonde (17).

15. Verfahren nach einem der Ansprüche von 11 bis 14, wobei der Schritt des Anordnens einer Sonde (17) in einem Luftspalt (4) des Wechselstromgenerators (1) ohne Demontage eines Rotors (2) des Wechselstromgenerators (1) durchgeführt wird.

16. Verfahren nach einem der Ansprüche von 11 bis 15, wobei der Schritt des Anordnens einer Sonde (17) in einem Luftspalt (4) des Wechselstromgenerators (1) ohne Demontage der Köpfe (7) des Wechselstromgenerators (1) durchgeführt wird.

## Revendications

1. Dispositif (15) pour inspecter un alternateur d'une installation de production d'énergie électrique comprenant :
- une sonde (17) ;
- de premiers moyens de déplacement (20) configurés pour déplacer la sonde (17) le long d'un axe de déplacement (V) situé sur un plan de déplacement ;
- au moins un premier élément d'entraînement (24, 44, 45) formé pour dévier la sonde (17) dans une première direction (D1, D2, D3) transversale à l'axe de déplacement (V) sur un premier côté du plan ;
le dispositif étant **caractérisé en ce que**, pendant l'utilisation, l'élément d'entraînement (24, 44, 45) est agencé de telle sorte que, une fois déviée, la sonde (17) pénètre à l'intérieur d'une fente (10) de l'alternateur.

2. Dispositif selon la revendication 1, comprenant au moins un deuxième élément d'entraînement (44, 45, 24) formé pour dévier la sonde (17) dans une deuxième direction (D2, D3, D1) transversale à l'axe de déplacement (V) sur un premier côté du plan.

3. Dispositif selon la revendication 2, comprenant au moins un troisième élément d'entraînement (45, 24, 44) formé pour dévier la sonde (17) dans une troisième direction (D3, D1, D2) transversale à l'axe de déplacement (V) sur un premier côté du plan.

4. Dispositif selon l'une quelconque des revendications précédentes, comprenant un poste de commande (25) configuré pour commander les premiers moyens de déplacement (20).

5. Dispositif selon la revendication 4, comprenant de seconds moyens de déplacement (21) configurés pour déplacer une extrémité (22) de la sonde (17).

6. Dispositif selon la revendication 5, dans lequel le poste de commande (25) est configuré pour commander les seconds moyens de déplacement (21).

7. Dispositif selon l'une quelconque des revendications de 4 à 6, dans lequel le poste de commande (25) comprend au moins une première commande manuelle configurée pour commander les premiers moyens de déplacement (20).

8. Dispositif selon l'une quelconque des revendications précédentes, comprenant au moins un détecteur d'images et au moins un moniteur (26), couplés à la sonde (17).

9. Dispositif selon l'une quelconque des revendications précédentes comprenant un chariot (16) muni d'un système de déplacement (28) ; le chariot (16) étant configuré pour supporter, au moins en partie, la sonde (17) et le premier élément d'entraînement (24, 44, 45).

10. Dispositif selon la revendication 9, dans lequel le chariot (16) comprend au moins un élément en matériau magnétique.

11. Procédé d'inspection d'un alternateur (1) d'une installation de production d'énergie électrique comprenant les étapes suivantes :
agencement d'une sonde (17) dans un entrefer (4) de l'alternateur (1) ; déplacement de la sonde (17) le long d'un axe de déplacement (V) situé sur un plan de déplacement ;
déviation de la sonde (17) selon une première direction (D1, D2, D3) transversale à l'axe de déplacement (V) sur un premier côté du plan ;
détection des images au moyen de la sonde (17) ;
le procédé étant **caractérisé en ce que** l'étape de déviation de la sonde (17) comprend la déviation de la sonde (17) de sorte que, une fois déviée, la sonde (17) pénètre à l'intérieur d'une fente (10) de l'alternateur.

12. Procédé selon la revendication 11, comprenant l'étape consistant à dévier la sonde (17) le long d'une deuxième direction (D2, D3, D1) transversale à l'axe de déplacement (V) sur un premier côté du plan.

13. Procédé selon la revendication 12, comprenant l'étape consistant à dévier la sonde selon une troisième direction (D3, D2, D1) transversale à l'axe de déplacement (V) sur un premier côté du plan.

14. Procédé selon l'une quelconque des revendications de 11 à 13, comprenant l'étape consistant à déplacer une extrémité (22) de la sonde (17).

15. Procédé selon l'une quelconque des revendications 11 à 14, dans lequel l'étape consistant à agencer une sonde (17) dans un entrefer (4) de l'alternateur (1) est réalisée sans démonter un rotor (2) de l'alternateur (1).

16. Procédé selon l'une quelconque des revendications 11 à 15, dans lequel l'étape d'agencement d'une sonde (17) dans un entrefer (4) de l'alternateur (1) est réalisée sans démontage des têtes (7) de l'alternateur (1).
